# DEMANDE DE BREVET EUROPEEN

(11) **EP 0 881 768 A1**
(43) Date de publication de la demande: **02.12.1998**
(21) Numéro de dépôt: 98401287.2
(22) Date de dépôt: 28.05.1998
(51) Int. Cl.: H03K 5/1252

(54) **Procédé et dispositif de filtrage d'un signal impulsionnel**

(30) Priorité: 30.05.1997 FR 9706703
(71) Demandeur: SGS-THOMSON MICROELECTRONICS S.A., 94250 Gentilly (FR)
(72) Inventeur: Leon, Jean-François, 94230 Cachan (FR)
(74) Mandataire: Ballot, Paul

(57) **Abrégé**

Dans un dispositif de filtrage impulsionnel (Sin), on échantillonne (1) le signal impulsionnel pour en permettre le comptage par un compteur asynchrone (2) et générer une impulsion de durée calibrée (dc) lorsque le comptage atteint un nombre déterminé (n0).

## Description

La présente invention concerne un procédé et un dispositif de filtrage d'un signal impulsionnel.

Dans les circuits électroniques à interface de transmission série, il est nécessaire de procéder au filtrage du signal d'entrée, pour supprimer les impulsions parasites de largeurs d'impulsion trop faibles. Si elles n'étaient pas filtrées, ces impulsions parasites pourraient provoquer des dysfonctionnements du circuit électronique. En effet, l'apparition d'une impulsion pourrait déclencher une opération particulière dans le circuit, mais la largeur de l'impulsion ne serait pas suffisante à assurer son déroulement complet. En outre il n'est pas admissible qu'une impulsion due à du bruit sur la ligne puisse déclencher une fonction du circuit électronique.

Pour ces raisons, un dispositif de filtrage est habituellement prévu, qui consiste en un filtre passe-bas RC.

L'utilisation d'un tel filtre passe-bas RC a cependant quelques inconvénients.

Les valeurs de résistance et de capacité du filtre RC peuvent varier d'un circuit électronique à l'autre, du fait des variations inhérentes au procédé de fabrication utilisé. Ces valeurs de résistance et de capacité vont aussi varier avec le niveau de la température ambiante sous laquelle opère le circuit électronique.

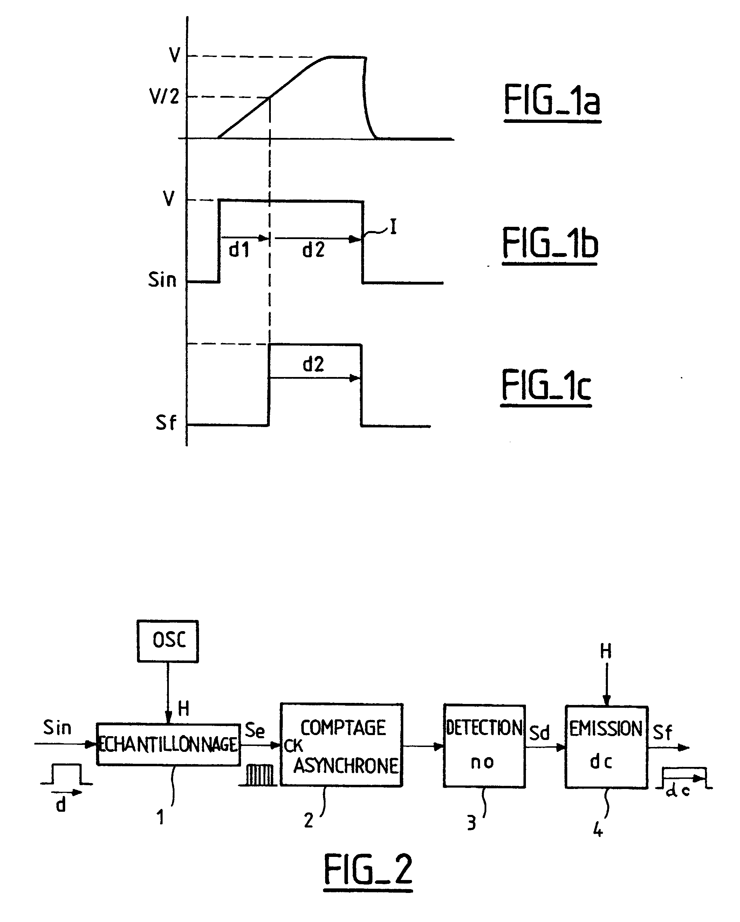

La valeur de coupure du filtre RC dépend directement de l'amplitude de l'impulsion. Ceci est illustré sur les figures 1a à 1c dans les dessins annexés.

Dans ces figures, le signal d'entrée est noté Sin et le signal de sortie filtré est noté Sf. La figure 1a montre la charge et décharge aux bornes du condensateur quand une impulsion I d'amplitude V se présente sur le signal d'entrée Sin (figure 1b). La valeur de coupure d1 du filtre RC passe-bas est donnée par V/2. Le signal filtré Sf (figure 1c) en sortie du filtre présente une impulsion raccourcie de la durée dl correspondant au temps de charge du condensateur de zéro à V/2.

Le signal filtré présente ainsi une impulsion de durée raccourcie d2 sur la figure. Un tel raccourcissement des largeurs d'impulsion est très gênant en pratique. En effet, on peut se retrouver avec une largeur d2 d'impulsion filtrée inférieure à la valeur de coupure d1. Par exemple, si on a un filtre RC pour filtrer les impulsions de largeurs inférieures à 300ns (d1=300ns) et que l'impulsion d'entrée a une largeur de 310ns, l'impulsion filtrée n'aura plus qu'une largeur d2 égale à 10ns, conduisant à un fonctionnement erratique du circuit électronique.

Avec un tel système de filtrage, on doit donc imposer comme spécification à l'utilisateur, de présenter des impulsions de largeur d bien supérieures à la valeur de coupure d1 du filtre, pour tenir compte de la zone de fonctionnement erratique.

Si d1 est la valeur de coupure, égale à la largeur minimum d'une impulsion pour un fonctionnement correct du circuit électronique, la spécification imposera comme largeur minimum dmin = 2.d1. Les trois zones de fonctionnement sont alors les suivantes, pour une impulsion d'entrée de largeur d :
- d < d1 : impulsion complètement filtrée
- d1 < d < 2.d1 : zone erratique de fonctionnement
- d > 2.d1 : zone de fonctionnement correct.

Enfin, on a vu que la valeur de coupure d1 du filtre dépend de l'amplitude V de l'impulsion. Dans un système de transmission utilisant la variation de l'amplitude de l'impulsion comme système de transmission d'information, un tel filtrage n'est donc pas applicable, puisqu'il imposerait des valeurs de coupure différentes selon l'amplitude de l'impulsion reçue.

L'invention a pour objet un dispositif de filtrage qui ne présente pas ces différents inconvénients.

Dans l'invention, on propose d'échantillonner le signal impulsionnel d'entrée pour en permettre le comptage par un compteur asynchrone et pour générer une impulsion de durée calibrée lorsque le comptage atteint un nombre déterminé.

En procédant ainsi, on n'a plus que deux zones de fonctionnement. Une impulsion d'entrée dont le comptage des échantillons n'atteint pas le nombre déterminé, est filtrée. Une impulsion d'entrée dont le comptage des échantillons atteint au moins le nombre déterminé est transformée en une impulsion de durée calibrée.

Cette durée calibrée est indépendante de l'impulsion d'entrée.

Elle est de préférence générée par un compteur synchrone.

Avec un tel procédé de filtrage, on n'a plus de dépendances au procédé de fabrication, à la température ambiante, ni même à l'amplitude de l'impulsion d'entrée.

Un tel procédé de filtrage offre une réponse particulièrement adaptée à la transmission d'information utilisant la variation de l'amplitude des impulsions.

Telle que caractérisée, l'invention concerne un dispositif de filtrage d'un signal d'entrée impulsionnel Sin.

Selon l'invention, le dispositif de filtrage comprend un circuit échantillonneur recevant en entrée le signal d'entrée impulsionnel Sin et délivrant en sortie un signal échantillonné, un compteur asynchrone recevant comme signal d'horloge, ledit signal échantillonné , un circuit de détection pour fournir un signal de détection quand le contenu du compteur asynchrone est supérieur ou égal à un nombre déterminé n0 et un circuit d'émission d'une impulsion calibrée dc commandé par ledit signal de détection.

De préférence, le circuit d'émission d'une impulsion calibrée comprend un compteur synchrone.

D'autres caractéristiques et avantages de l'invention sont détaillés dans la description suivante faite à titre indicatif et non limitatif, en référence aux dessins annexés, dans lesquels :
- les figures 1a à 1c déjà commentées illustrent le filtrage par filtre passe-bas de type RC;
- la figure 2 représente un schéma fonctionnel d'un dispositif de filtrage selon l'invention;
- la figure 3 représente un schéma détaillé d'un mode de réalisation de l'invention et
- la figure 4 représente un chronogramme des signaux correspondants.

La figure 2 représente un schéma fonctionnel d'un dispositif de filtrage d'un signal impulsionnel selon l'invention.

Le dispositif comprend un circuit échantillonneur 1 recevant en entrée, le signal impulsionnel à filtrer noté Sin et un signal d'horloge H, stable, fourni de manière classique par un oscillateur OSC du circuit électronique. Le circuit échantillonneur 1 délivre en sortie un signal échantillonné Se. Si le signal d'entrée Se a une largeur d'impulsion d, le signal échantillonné comprend alors n impulsions d'horloge H.

Ce signal échantillonné Se est appliqué sur l'entrée horloge CK d'un compteur asynchrone 2 suivi d'un circuit de détection 3 pour détecter si le comptage des échantillons atteint un nombre déterminé n0. Ce circuit de détection 3 génère un signal de détection Sd, quand le nombre n0 est atteint, pour déclencher l'émission d'une impulsion de durée calibrée dc. Le circuit 4 pour émettre cette impulsion de durée calibrée comme signal filtré Sf sera de préférence un compteur synchrone. Dans l'exemple, ce circuit 4 reçoit comme horloge de comptage, l'horloge H.

On rappelle qu'un compteur est constitué de plusieurs bascules montées en cascade, chaque bascule constituant un étage du compteur. La sortie de chaque étage représente un bit du compteur. Dans un compteur synchrone, les étages reçoivent le même signal d'horloge.

Dans un compteur asynchrone, les étages ne sont pas commandées par la même horloge. Le premier étage reçoit un signal d'horloge CK, le deuxième étage reçoit comme signal d'horloge, la sortie de l'étage précédent et ainsi de suite. D'une manière générale, le signal d'horloge d'un étage de rang n n'est autre que la sortie de l'étage de rang n-1.

Dans l'invention, on applique comme signal d'horloge du compteur asynchrone 2 (sous-entendu, du premier étage), le signal échantillonné Se. Le compteur asynchrone peut ainsi compter les échantillons contenus dans la largeur d de l'impulsion du signal d'entrée Sin. En comparant le contenu du compteur asynchrone 2 à la valeur déterminée n0, on détermine si l'impulsion a une largeur supérieure ou égale à la valeur de coupure (ou de filtrage). Le compteur asynchrone doit être réinitialisé pour chaque nouvelle impulsion qui se présente sur le signal d'entrée Sin.

Le compteur synchrone 4 lui est dimensionné pour émettre une impulsion de largeur calibrée dc en sortie, correspondant à nc coups d'horloge H. Il est activé et réinitialisé quand une impulsion d'entrée est détectée comme étant de largeur suffisante (Sd) et désactivé dès qu'il a émis l'impulsion calibrée en sortie Sf.

Avec un tel procédé, le filtrage est invariant avec l'amplitude des impulsions d'entrée, le procédé de fabrication et la température ambiante sous laquelle opère le circuit électronique. Il n'y a plus que deux zones de fonctionnement, délimitées par la valeur de coupure établie par la valeur de détection n0.

Ces deux zones correspondent chacune à un fonctionnement bien déterminé.

On résout ainsi tous les problèmes rencontrés avec un filtrage plus classique (RC).

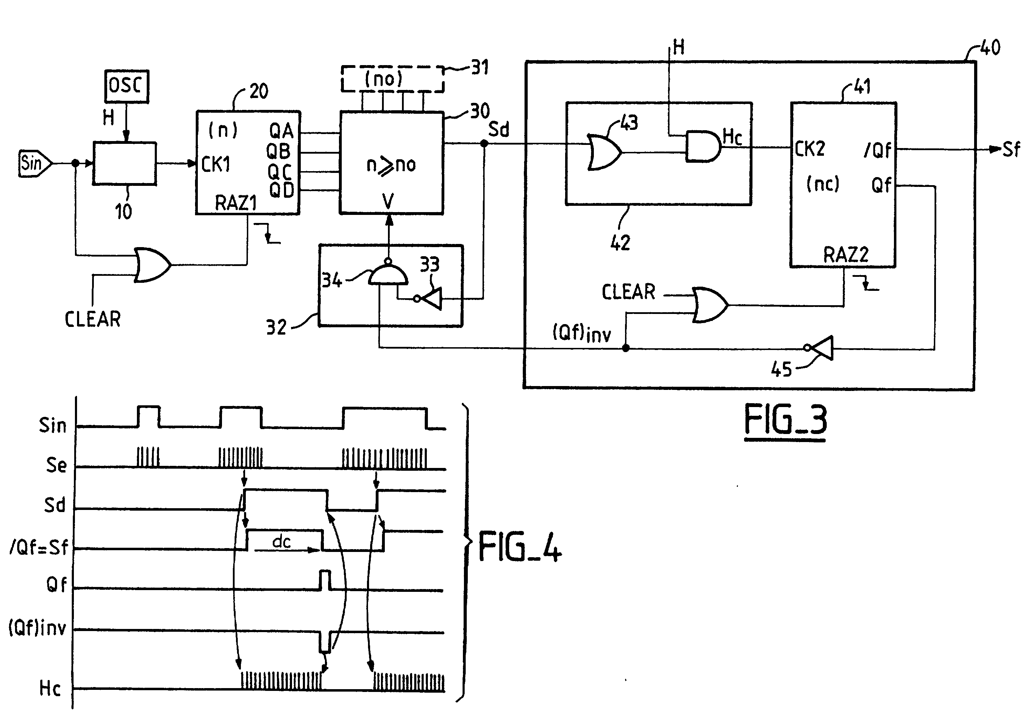

Sur la figure 3, on a représenté un schéma détaillé d'un mode de réalisation d'un dispositif selon l'invention. La figure 4 montre le chronogramme des signaux correspondant à ce schéma.

Le signal impulsionnel d'entrée Sin est appliqué en entrée d'un échantillonneur 10 recevant une horloge H stabilisée. Le signal échantillonné Se est appliqué sur l'entrée horloge CK1 d'un compteur asynchrone 20. Ce compteur comprend une entrée de remise à zéro RAZ1 active sur un front descendant, et délivre son contenu en sortie QA, QB, QC, QD représentant chacune un bit du compteur, respectivement le bit de poids 0, 1, 2 et 3. Le compteur asynchrone 20 peut-être remis à zéro par un signal CLEAR issu d'un dispositif de commande du circuit électronique ou à chaque fin d'impulsion (front descendant) du signal d'entrée Sin. Ainsi le compteur est prêt à compter le nombre d'échantillons de l'impulsion suivante.

Les bits de sortie du compteur sont appliqués en entrée d'un circuit de détection 30. Ce circuit de détection a pour fonction de détecter si le contenu du compteur est égal ou supérieur à un nombre déterminé n0.

Cette détection peut se faire par décodage des bits de sortie du compteur. Par exemple, si n0=8, il suffit de décoder (QD=1) pour savoir si le contenu du compteur est supérieur ou égal à ce nombre déterminé n0. Cette détection peut encore se faire par un comparateur qui reçoit alors la valeur n0 à comparer d'un registre 31 (en pointillé sur la figure) du circuit électronique. Cette dernière solution est plus souple, puisqu'elle permet de programmer la valeur de comparaison.

Si le comptage par le compteur asynchrone 20 atteint la valeur déterminée n0, la sortie Sd du circuit de détection 30 passe à un niveau actif, 1 dans l'exemple. Le niveau actif du signal Sd est alors utilisé pour désactiver le circuit de détection, au moyen d'un circuit logique 32. En effet, il faut dans l'exemple, maintenir Sd à 1 tant que l'impulsion calibrée n'a pas été émise en sortie Sf.

Le circuit logique 32 impose ainsi un niveau inactif, 1 dans l'exemple, sur un signal de validation V du circuit de détection 30, lorsque le signal Sd passe à son niveau actif. L'invalidation du circuit de détection 30 a pour effet d'isoler la sortie Sd des entrées.

De cette manière le compteur asynchrone 20 peut être réinitialisé pour une nouvelle impulsion et/ou continuer à compter, la sortie Sd restera inchangée, à son niveau actif 1.

Le circuit logique 32 permet aussi d'imposer à nouveau un niveau actif O pour ré-activer le circuit de détection 30, quand l'impulsion calibrée a été émise en sortie Sf. En effet, quand l'impulsion calibrée a été émise en sortie Sf, le circuit de détection peut prendre en compte le nouveau contenu du compteur.

Pour réaliser ces fonctions d'invalidation/réactivation, le circuit logique 32 comprend dans l'exemple un inverseur 33 pour inverser le signal Sd et une porte NON ou EXCLUSIF recevant en entrée le signal inversé /Sd et un signal noté (Qf)ᵢₙᵥ indiquant à l'état 0 que l'impulsion de durée calibrée a été émise en sortie Sf.

Le signal de détection Sd est appliqué à un circuit 40 d'émission d'une impulsion calibrée, de largeur (durée) dc. Dans l'exemple, ce circuit d'émission 40 comprend un compteur synchrone 41 dont on utilise les deux bits complémentaires Qf et /Qf de sortie de l'étage de rang f, correspondant au comptage de nc impulsions d'horloges. nc impulsions d'horloge H correspondent à la largeur calibrée dc des impulsions obtenues en sortie Qf et /Qf.

Ce compteur synchrone 41 est réinitialisé par un front descendant sur l'entrée RAZ2, apparaissant soit sur le signal CLEAR, soit sur le signal de fin de génération de l'impulsion calibrée (Qf)ᵢₙᵥ.

Ce compteur synchrone 41 reçoit une horloge de comptage Hc sur son entrée horloge CK2. Cette horloge de comptage est fournie par un ensemble 42 de portes logiques, à partir du signal d'horloge H.

Cette horloge H doit en effet être appliquée comme horloge de comptage Hc dès que le signal Sd passe à 1, le compteur 41 étant dans un état réinitialisé et ne plus être appliqué dès que l'impulsion calibrée a été émise, comme clairement représenté sur la figure 4. Dans l'exemple représenté, on applique le signal déjà vu, noté (Qf)ᵢₙᵥ et le signal Sd en entrées d'une porte NON OU EXCLUSIF 43 pour fournir un signal de comptage Sdc. Ce signal Sdc est appliqué avec l'horloge H en entrées d'une porte ET 44 pour fournir le signal d'horloge de comptage Hc.

Le signal de sortie filtré Sf est alors fourni par le bit complémentaire /Qf de l'étage de rang f du compteur, dont le front montant de l'impulsion calibrée apparaît avec la première impulsion d'horloge de comptage et dont le front descendant apparaît avec la nc-ième impulsion de l'horloge de comptage Hc.

Le bit Qf de l'horloge de comptage est tel qu'il reste à zéro pour les nc-ièmes premières impulsions et monte à 1 (front montant) avec la nc+1-ième impulsion d'horloge de comptage Hc. C'est ce bit Qf qui est utilisé pour générer le signal de fin de génération d'impulsion calibrée, signal noté (Qf)ᵢₙᵥ et délivré par un inverseur 45. Ce signal (Qf)ᵢₙᵥ est donc à 1 à la ré-initialisation du compteur synchrone 41 et passe à zéro (front descendant) quand le bit Qf passe à 1. C'est ce passage à zéro du signal (Qf)ᵢₙᵥ qui est utilisé dans le dispositif pour revalider le signal de validation V du circuit de détection (circuit logique 32) et pour stopper l'horloge de comptage Hc.

On remarquera que l'on ne peut pas utiliser le signal Sd pour stopper l'horloge de comptage Hc, car lorsque le circuit de détection est revalidé par le signal (Qf)ᵢₙᵥ, le circuit de détection prend le contenu courant du compteur qui peut déjà avoir pris en compte une nouvelle impulsion et avoir dépassé le nombre n0. La logique du circuit 40 ne verrait alors pas de passage à zéro du signal Sd et le compteur synchrone ne pourrait donc pas être réinitialisé, en absence de front descendant détectable sur ce signal.

En outre la sortie Sd ne peut repasser à zéro qu'avec le signal (Qf)ᵢₙᵥ qui ré-active le circuit de détection 30.

Les chronogrammes des signaux sont représentés sur la figure 4.

Le schéma détaillé d'un dispositif de filtrage selon l'invention décrit en relation avec les figures 3 et 4 n'est qu'un exemple de réalisation. D'autres réalisations sont envisageables qui restent du domaine de l'invention.

## Revendications

1. Dispositif de filtrage d'un signal d'entrée impulsionnel (Sin), caractérisé en ce qu'il comprend un circuit échantillonneur (10) recevant en entrée le signal d'entrée impulsionnel (Sin) et délivrant en sortie un signal échantillonné (Se), un compteur asynchrone (20) recevant comme signal d'horloge (CK1), ledit signal échantillonné (Se), un circuit de détection (30) pour fournir un signal de détection (Sd) quand le contenu du compteur asynchrone est supérieur ou égal à un nombre déterminé (n0) et un circuit (40) d'émission d'une impulsion calibrée (dc) commandé par ledit signal de détection (Sd).

2. Dispositif de filtrage selon la revendication 1, caractérisé en ce que le circuit d'émission d'une impulsion calibrée (40) comprend un compteur synchrone (41).

3. Procédé de filtrage d'un signal d'entrée impulsionnel (Sin), caractérisé en ce qu'il consiste à échantillonner ledit signal d'entrée et à appliquer le signal échantillonné (Se) comme horloge de comptage (CK1) d'un compteur asynchrone (2), ledit compteur effectuant un comptage des échantillons de chaque impulsion du signal d'entrée, pour permettre la comparaison du nombre d'échantillon à un nombre déterminé (n0) et générer une impulsion de durée calibrée (dc) dès que ledit nombre d'échantillons compté égale ou dépasse ledit nombre déterminé (n0).

4. Procédé de filtrage d'un signal d'entrée impulsionnel (Sin) selon la revendication 3, caractérisé en ce qu'il utilise un compteur synchrone (41) pour générer ladite impulsion de durée calibrée (dc).
